Europäisches Patentamt

European Patent Office

Office européen des brevets

(11) Publication number: **0 149 550 B1**

# EUROPEAN PATENT SPECIFICATION

(45) Date of publication of patent specification: **24.02.93**    (51) Int. Cl.5: **H04N 3/12**

(21) Application number: **85300245.9**

(22) Date of filing: **14.01.85**

(54) **Video display systems.**

(30) Priority: **13.01.84 JP 5389/84**
     **27.01.84 JP 13877/84**

(43) Date of publication of application:
     **24.07.85 Bulletin 85/30**

(45) Publication of the grant of the patent:
     **24.02.93 Bulletin 93/08**

(84) Designated Contracting States:
     **DE FR GB IT NL**

(56) References cited:
     **EP-A- 0 078 402**
     **GB-A- 2 047 453**
     **GB-A- 2 084 778**

     **JOURNAL OF ELECTRONIC ENGINEERING,
     vol. 18, no. 177, September 1981, pages
     55-59, Tokyo, JP; M. TAMURA:
     "Developmental pace picking up for VFDs
     for TV video image"**

(73) Proprietor: **SONY CORPORATION**
     **7-35 Kitashinagawa 6-chome Shinagawa-ku
     Tokyo 141(JP)**

(72) Inventor: **Watanabe, Yuji c/o Sony Corpora-
     tion**
     **Patents Division 7-35 Kitashinagawa
     6-chome**
     **Shinagawa-ku Tokyo(JP)**

(74) Representative: **Cotter, Ivan John et al
     D. YOUNG & CO. 10 Staple Inn
     London WC1V 7RD (GB)**

## Description

This invention relates to video display systems.

A video display device or system in which a plurality of display cells are arranged in a two-dimensional or X-Y matrix form and the cells are respectively driven by desired data to display a desired image a picture has already been proposed.

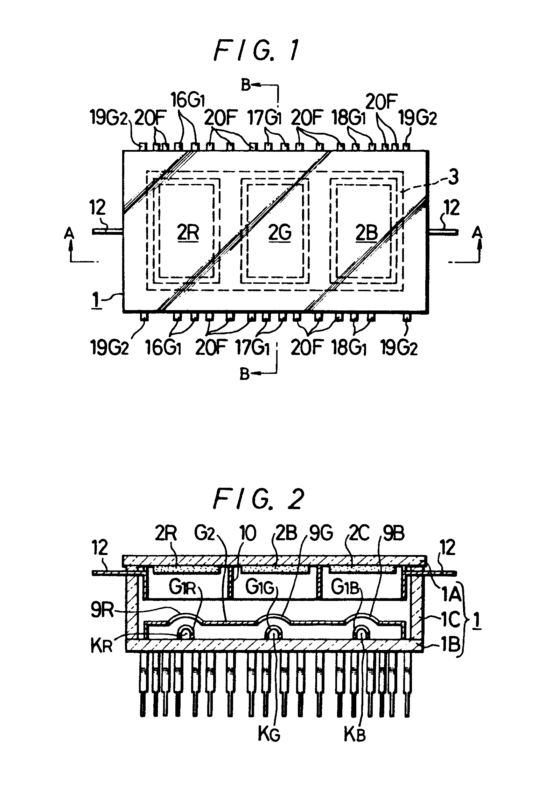

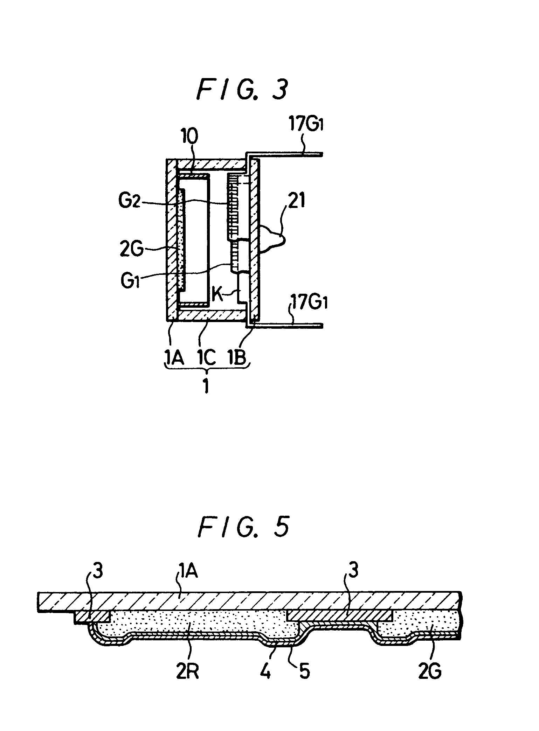

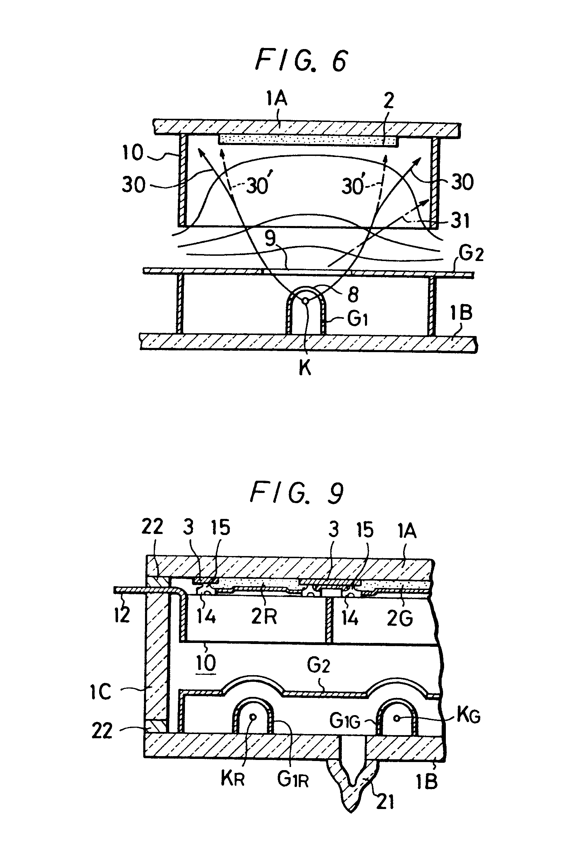

The present applicants have proposed a luminescent display cell that can be used in the above-mentioned video display device. The previously proposed luminescent display cell is shown in Figures 1 to 4 of the accompanying drawings which are, respectively, a front view of the cell, a sectional view taken on a line A-A in Figure 1, a sectional view taken on a line B-B in Figure 1, and a partially cut-away perspective view of the cell. The cell includes a glass envelope 1 comprising a front panel 1A, a rear panel or plate 1B and a side wall 1C. Within the glass envelope 1 are disposed a plurality of luminescent display segments or elements 2 (2R, 2G, 2B), a plurality of cathodes K ($K_R$, $K_G$, $K_B$) and first grids $G_1$ ($G_{1R}$, $G_{1G}$, $G_{1B}$) in corresponding relation to each display segment, and a common second grid (accelerating electrode) $G_2$. Preferably, as shown, the cathodes K are wire cathodes. The display segments 2 each comprise a phosphor layer formed on the inner surface of the front panel 1A. Three display segments 2R, 2G, and 2B are formed for the luminescence of red, green and blue, respectively. More particularly, as shown in Figure 5, a carbon layer 3, acting as a conductive layer, is printed in the form of a frame on the inner surface of the front panel 1A. The display segments 2R, 2G and 2B are formed by printing phosphor layers in spaces in the frame formed by the carbon layer 3 so as partially to overlap the carbon layer 3. A metal backing layer 5, e.g. of aluminium, is formed over all the surfaces of the phosphor layers, a filming layer 4 being disposed between the backing layer 5 and the phosphor layers. Furthermore, in opposed relation to the display segments 2R, 2G and 2B comprising the above-mentioned phosphor layers, and inside the rear panel 1B, there are positioned the wire cathodes $K_R$, $K_G$ and $K_B$, the first grids $G_{1R}$, $G_{1G}$ and $G_{1B}$ opposite the wire cathodes, and the second grid $G_2$ in common to the three first grids $G_{1R}$, $G_{1G}$ and $G_{1B}$. Each wire cathode K is formed, for example, by coating the surface of a tungsten heater with carbonate as an electron emissive material. The wire cathodes $K_R$, $K_G$ and $K_B$ are each stretched between a pair of conductive support members 6 and 7 which are disposed on opposite side portions of the rear panel 1B. One support member 6 is for fixing one end of each wire cathode, while the other support member 7 is provided with a spring portion 7a to which the other end of each wire cathode is fixed. According to this arrangement, an even extension of each wire cathode K due to a rise in temperature will be absorbed by the spring portion 7a, so that the wire cathode never becomes loose. Each of the first grids $G_{1R}$, $G_{1G}$ and $G_{1B}$ is formed in a half-cylindrical shape having a cylindrical surface in corresponding relation to one of the wire cathodes K, and a plurality of slits 8 are formed in the cylindrical surface at a predetermined pitch along the longitudinal direction of the cylindrical surface. The slits 8 are for the transmission therethrough of electrons radiated from the wire cathode K. The second grid $G_2$ is formed with slits 9 (9R, 9G and 9B) in portions corresponding to the first grids $G_{1R}$, $G_{1G}$ and $G_{1B}$ and in positions corresponding to the slits 8 of the first grids. The portions of the second grid $G_2$ having the slits 9R, 9G and 9B may be formed so as to have cylindrical surfaces concentric or coaxial with the corresponding first grids $G_{1R}$, $G_{1G}$ and $G_{1B}$. With this construction, electron beams 30 from the wire cathodes K are radiated rectilinearly through the slits 8 and 9 of the first and second grids $G_1$ and $G_2$ and are spread with respect to the longitudinal direction of the slits. Alternatively, as shown in Figure 6, the portions of the second grid $G_2$ in which the slits 9 are formed may be horizontal or planar. In this case, the electron beam is radiated so that it passes through the second grid $G_2$ and then is curved somewhat inwardly with respect to the longitudinal direction of the slits, as shown by a dotted line 30' in Figure 6.

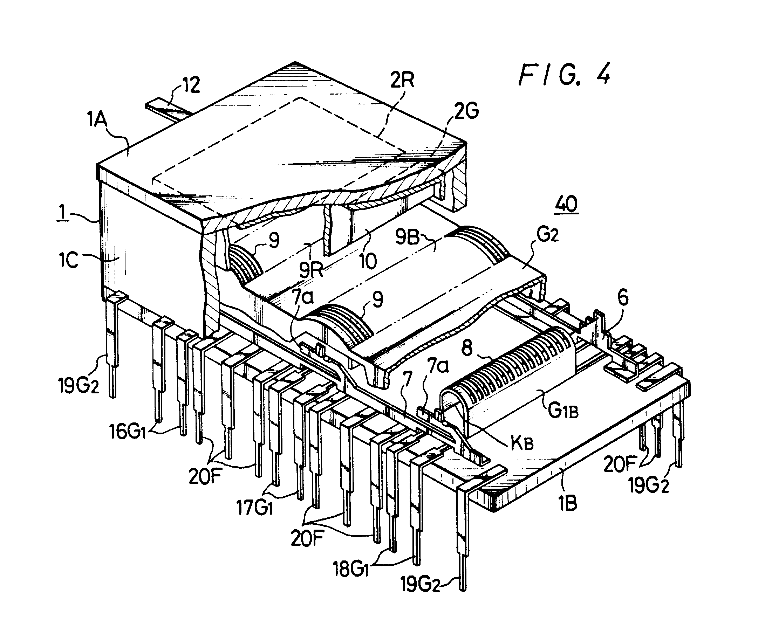

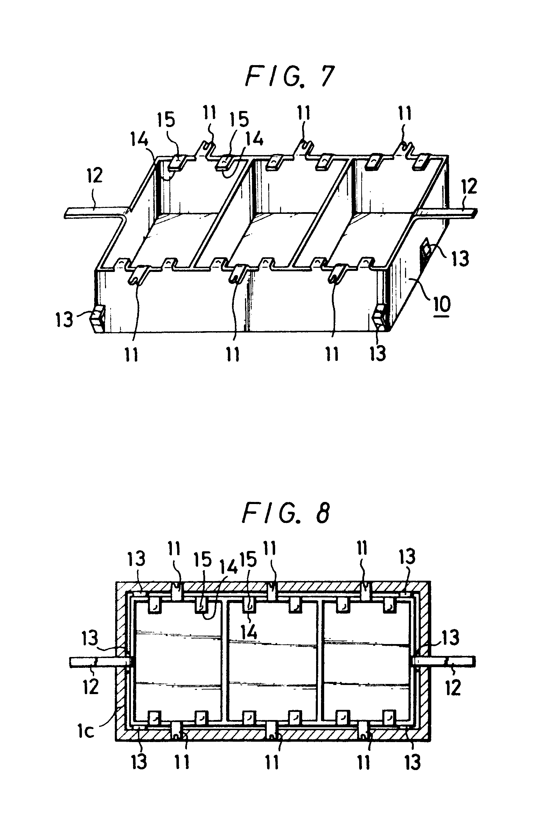

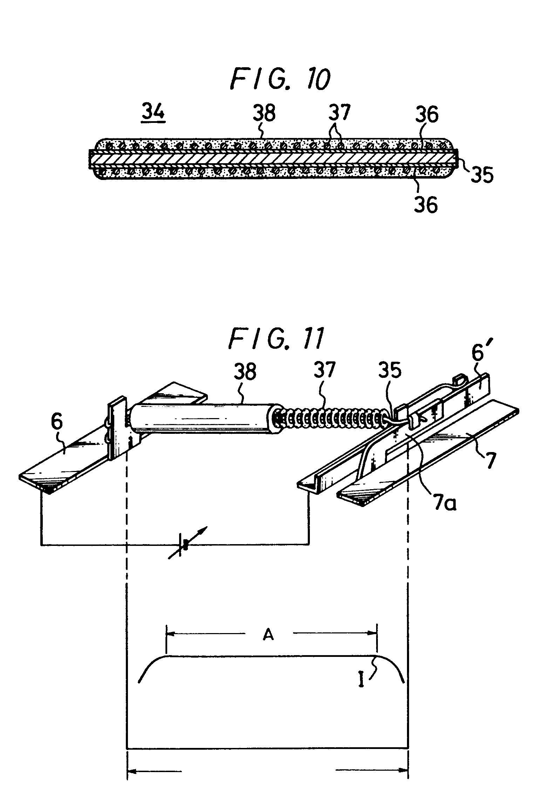

A separator 10 formed of a conductive material is disposed to surround the display segments or elements 2R, 2G and 2B. The separator 10 not only serves as a shield for preventing secondary electrons 31 (see Figure 6), induced by impingement of the electron beam 30 from a wire cathode K against the first or second grid $G_1$ or $G_2$, from rendering an adjacent display segment luminous, but serves also to form a diffusion lens which functions to spread the electron beam 30 from each wire cathode K so that the electron beam is radiated throughout the corresponding display segment 2. In addition, the separator 10 is used also as power supply means for supplying a high voltage (e.g. 10 kV) to each display segment. In assembling the cell, the separator 10 is supported between the front panel 1A and side wall 1C of the glass envelope 1 and fixed by frit. More specifically, as shown in Figure 7, the separator 10 is in the form of a frame partitioned into three to surround the display segments in the manner of a honey-comb, and outwardly projecting supporting pieces 11 are formed on first opposed upper ends thereof while anode leads 12 are formed on the other opposed upper ends for the supply of high voltage (anode voltage). Furthermore, outwardly bent elastic positioning portions or pieces 13 are formed on the side portions of the separator 10. When the separator 10 is inserted from above into the inside of the side wall 1C, as shown in Figure 8, the supporting pieces 11 abut the upper end face of the side wall 1C to thereby support the separator 10 and, at the same time, the bent portions 13 abut the inner surface of the side wall 1C to thereby position the separator 10 in central fashion. Also provided on the upper end portion of the separator 10 are inwardly bent lugs 14 each having a projection 15 formed on the surface thereof. When the front panel 1A is placed and sealed on the side wall 1C after enclosing the separator 10 in the side wall 1C, the projections 15 contact the carbon layer 3 or the metal backing layer 5 (see Figure 9). As a result, the high voltage from the anode leads 12 is fed in common to the display segments 2R, 2G and 2B. In the assembled state, the anode leads 12 to which the high voltage is applied are led or extend out to the exterior through the sealed portion between the front panel 1A and the upper end face of the side wall 1C, while the leads of the wire cathodes K, first grid $G_1$, and second grid $G_2$ are led or extend out to the exterior through a sealed portion between the rear plate 1B and the side wall 1C. The leads of the cathodes K, first grids $G_1$, and second grid $G_2$ are brought out together for supporting purposes. For example, in each of the first grids $G_{1R}$, $G_{1G}$ and $G_{1B}$, two leads on each side, namely a total of four leads on both sides, are brought out as leads $16G_1$, $17G_1$, and $18G_1$ (see Figure 4). In the case of the second grid $G_2$, four leads $19G_2$ are brought out, corresponding to the four corners of the rear panel 1B. Leads 20F of the cathodes K are brought out together to the right and left from both support members 6 and 7. The leads 20F of the cathodes are connected in common for each of the support members 6 and 7. Also, with respect to each of the first and second grids $G_1$ and $G_2$, the corresponding leads are connected in common.

The glass envelope 1 is completed or assembled by sealing the front panel 1A, side wall 1C and rear plate 1B with respect to each other by frits 22 (see Figure 9). A chip-off pipe 21 for gas exhaust is fixed by frits to the rear plate 1B.

The operation of the cell of the above construction will now be explained. An anode voltage of, say, 10 kV or so is supplied through the anode leads 12 to the red, green and blue display segments 2R, 2G and 2B. A voltage of, say, 0-30V is applied to each of the first grids $G_{1R}$, $G_{1G}$ and $G_{1B}$, while a voltage of, say, 300V is applied to the second grid $G_2$. The wire cathodes $K_R$, $K_G$ and $K_B$ produce 60-70 mW or so per wire. In this construction, the anode side and the second grid $G_2$ are fixed in voltage, while the voltage applied to the first grids $G_1$ is changed so as selectively to turn on and off the display segments. More particularly, when OV is applied to a first grid $G_1$, an electron beam from the corresponding cathode K is cut off and the corresponding display segment 2 is not rendered luminous. When, say, 30 V is applied to a first grid $G_1$, an electron beam from the corresponding cathode K passes through the first grid $G_1$, and is then accelerated by the second grid $G_2$ and impinges upon the phosphor of the corresponding display segment 2 to make the display segment luminous. The luminance is controlled by controlling the pulse width (duration) of the voltage (30 V) applied to the first grid $G_1$. Further, as shown in Figure 6, the electron beam from the cathode K is spread by the separator 10 and radiated to the entire surface of the display segment 2. When the electron beam from the cathode K impinges upon the first and second grids $G_1$ and $G_2$, the secondary electrons 31 are produced from these grids. However, the secondary electrons 31 are obstructed by the separator 10 so they do not impinge upon the adjacent display segment 2. In this way, by selectively controlling the voltage applied to the first grids, the display segments 2R, 2G and 2B are rendered luminous selectively at a high luminance.

This luminescent display cell 40 is constructed in thin fashion as a whole. Also, the low voltage-side leads such as the cathode and first and second grid leads are led or extend out from the rear panel 1B side of the glass envelope 1, while the high voltage-side anode leads 12 are led or extend out from the front panel 1A side. Therefore, possible dangers during discharge and wiring can be avoided, thus ensuring a stable luminescent display.

Moreover, since the separator 10, to which the anode voltage is applied, surrounds each display segment 2, a diffusion lens is formed by the separator 10. Therefore, even if only the first grids $G_1$ are curved and the second grid $G_2$ is flat or planar (as shown in Figure 6), the electron beam from each cathode K spreads laterally (in the direction of the slits 8 and 9) and is radiated to the entire surface of the display segment 2. At the same time, secondary electrons from the first and/or second grids $G_1$ and $G_2$ are obstructed by the separator 10, so the adjacent cut-off segment is not rendered luminous.

In the case of a colour display (for example, in the case of a 9300ºK white picture), the luminance mixing ratio is about 7% blue, about 13% red, and about 80% green. In the case where wire cathodes are used as an electron emission source, they are in many cases used in a temperature restriction area in order to maintain their service life. The problem of making the luminance of the green cathode higher than that of the other cathodes can be solved by increasing the number of green cathodes used. For example, two green cathodes $K_G$, one red cathode $K_R$, and one blue cathode $K_B$ may be used. As a result, the total amount of electrons for green becomes larger than that for red and blue, thus making it possible to effect a colour display. The red and blue cathodes also may be used in plural numbers, which is effective in prolonging their service life. Thus, by increasing the number of green cathodes in comparison with the other cathodes, the luminance of green can be enhanced and a good white balance is obtainable. Consequently, an excessive load is not imposed on the cathodes, that is, the life of the luminescent display cell can be prolonged. In practice, two green cathodes may be disposed in spaced relation at a distance of about 0.8 to 1 mm. As to the amount of electrons emitted, an increase of 70 to 80% can be expected: the amount of electrons does not become twice as large as that in the case of a single green cathode due to the electron scattering effect. Alternatively, the green luminance may be enhanced by making the area of the green phosphor layer larger than of the red and blue phosphor layers.

Since the wire cathodes are used in the temperature restriction area, that is, the loading of the oxide cathode is set at a ratio of one to several tens to prevent a red-looking appearance, the amount of electrons emitted per cathode is small. One method of solving this problem may be to substantially enlarge the surface area of oxide by winding a tungsten wire spirally, for example. But, in the case of a long spiral, it is likely that loosening or vibration of the cathode will occur. In view of this point, a construction as shown in Figure 10 and 11 may be employed.

In the construction of Figures 10 and 11, a core 35 formed of a high-temperature material such as, for example, tungsten or molybdenum, is provided, and its surface is coated with an insulating material 36 such $Al_2O_3$. Then, tungsten wire 37 serving as a heater is wound spirally thereon and an electron emissive material 38, e.g. carbonate, is bonded to the spiral portion by spraying or electrodeposition to constitute a direct heating cathode 34. The core 35 is fixed at one end thereof to one support member 6 and at the other end thereof to the spring portion 7a of the other support member 7 by spot welding or other suitable means, so as to be stretched under tension. the tungsten wire 37 is fixed between one support member 6 and a second support member 6' on the other side by spot welding or other suitable means.

Thus, in the above construction, the cathode is wound spirally onto the core 35 coated with the insulating material 36, and the core 35 is stretched by the spring portion 7a, whereby problems such as shorting between spiral portions and thermal deformation of the spiral can be eliminated. Also, the oxide surface area is substantially increased, and a uniform temperature distribution area (A) with reduced temperature difference between both ends and the centre of the cathode becomes wider. As a result, the amount of electrons emitted can be increased, and as a whole, therefore, it is possible to increase the amount of allowable current per cathode. The curve I in Figure 11 represents the temperature distribution.

In the luminescent display cell formed as described above, since the separator 10 supplied with the same high voltage as that applied to the display segments or elements 2 is positioned to surround the plural display segments, a diffusion lens is formed whereby an electron beam from the cathode K is spread laterally and radiated to the entire surface of each display segment or element. Consequently, it is possible to provide a high luminance display. Furthermore, by virtue of the presence of the separator 10, secondary electrons from a control electrode or accelerating electrode are obstructed, so as not to render the adjacent cut-off display segment luminous, and a stable luminescent display can thus be effected.

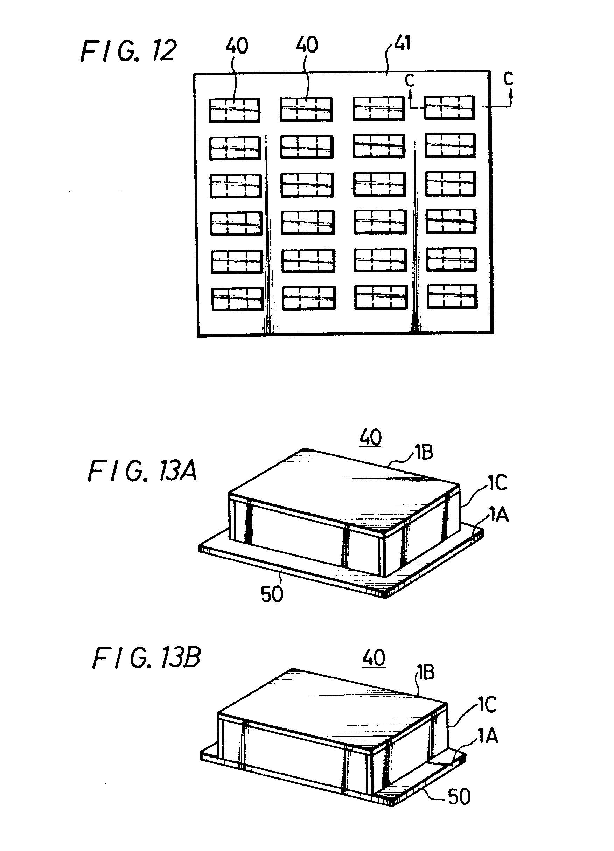

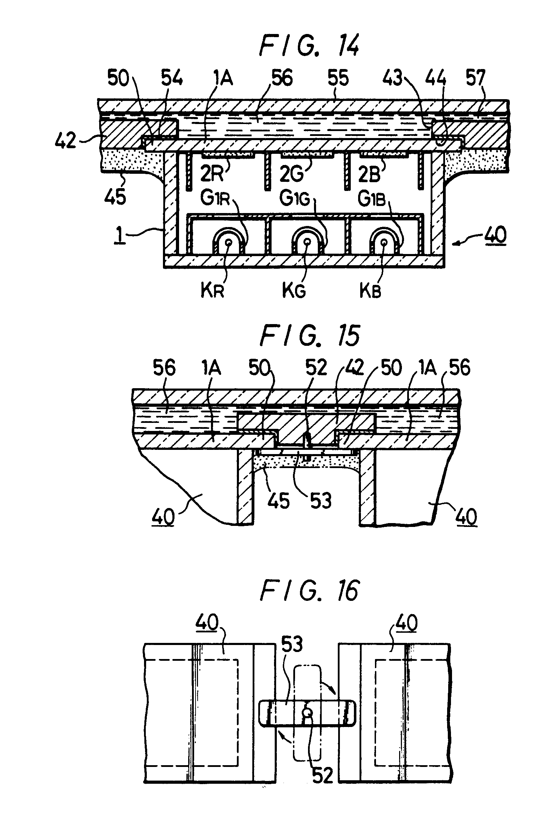

To make a picture display system or device using the above-described luminescent display cell, the following assembly procedure is adopted. A plurality of the above-described luminescent display cells 40, for example 6 (column) x 4 (row) = 24 cells, are incorporated in a unit case 41 to form one unit, as shown in Figure 12. In mounting such plural display cells 40 to the unit case 41, the cells 40 are fixed to the case 41 by moulding with resin or the like. However, the anode voltage of the display cell 40 is as high as about 10 kV so that, if the fixing is incomplete, the display cell 40 may become separated upon application of power from the surface or the application to the surface of a liquid for removing stains or the like. A change in conditions also may cause such trouble. Therefore, it is necessary to fix the display cells 40 firmly to the unit case 41. For this purpose, each display cell 40 is formed so that the front panel 1A of the glass envelope 1 overhangs outwardly beyond the side wall 1C. In this case, the front panel 1A may overhang throughout the circumference, as shown in Figure 13A, or it may overhang only in one direction as shown in Figure 13B. The unit case 41 is constructed as shown in Figure 14, that is, plural (24 in the illustrated embodiment) window holes 43 are formed in a front plate 42 of the unit case 41 in opposed relation to the display cells 40, and a stepped portion 44 in which the marginal portion of the front panel 1A of each display cell is to be fitted is formed in the back of the marginal portion of each window hole 43. The display cell 40 is fitted in the back of the front plate 42 so that its front panel 1A faces the window hole 43, and then is fixed from the back by the user of a fixing means or member 45 such as a resin mould or the like. In this case, since the front panel 1A overhangs outwardly as an overhang portion 50, the overhang portion 50 is held between the fixing member 45 and the front plate 42 of the unit case 41, and thus, as a whole, the display cell 40 is fixed firmly to the unit case 41. If necessary, as shown in Figures 15 and 16, there may be provided a retaining piece 53 which is rotatable about a shaft 52 to hold the overhang portion 50 of the front panel 1A of each display cell 40 between it and the front plate 42 of the unit case 41. Subsequent fixing with resin mould or the like will further ensure the fixing of the display cell. Since the display cell is of a high luminance, the front panel side with phosphor layers applied thereto is apt to become high in temperature, so it is necessary to cool it, for example with liquid. For this purpose, at the time of mounting each display cell 40 to the unit case 41, a packing 54, e.g. of silicone rubber, is interposed between the stepped portion 44 of the front plate 42 of the unit case 41 and the front panel 1A, and a transparent plate 55 formed of polycarbonate or other material is disposed thereabove, and the space formed by the transparent plate 55, the front panel 1A and the window hole 43 of the unit case 41 is filled with a cooling liquid 56. In this case, the front plate 42 of the unit case 41 is formed with cooling liquid introduction slots 57 communicating with the window holes 43. Instead of using the cooling liquid 56, a fan may be provided to perform air-cooling of the display cell.

Then, a plurality of the above units are arranged in an X-Y matrix form, for example 7 (column) x 5 (row) = 35 units, to form a block, and five blocks are then arranged laterally to form a sub-module. Then, a plurality of the sub-modules are combined in an X-Y matrix form, for example 9 (column) x 4 (row) = 36. By using a number of the sub-modules, a jumbo-size picture display device or "tube" of, for example, 25 m (column) x 40 m (row), can be constructed. In this case, the number of display cells is

36 x 5 x 35 x 24 = 151,200

and the number of display segments is 3 times the above number and thus is about 450,000.

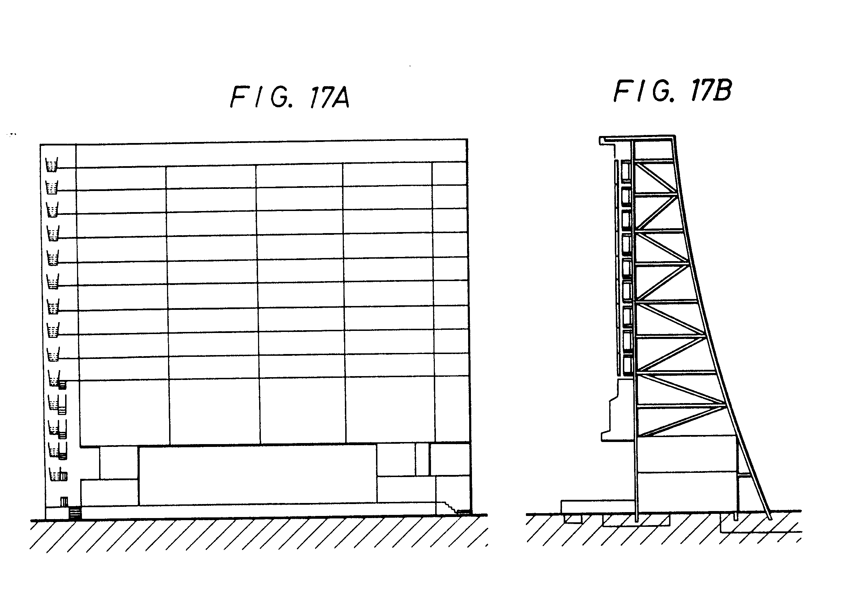

Figures 17A and 17B are, respectively, a front view and a cross-sectional view of the whole of a built-up jumbo-size picture display device. The whole of the jumbo-size picture display device is a building or edifice which is, for example, 42 m in height and 47 m in width. The upper portion of the building is made as a display portion which is provided with 9 floors, each floor having a height of 2.688 m. On each floor there are located 4 sub-modules in the lateral direction. Further, on the lower portion of the building there are formed a stage for entertainment, an anteroom, a central control room for operating and managing the display device and the stage, and so on.

In the above-described way, the picture display device is built. In this case, since 24 luminescent display cells form a unit and a plurality of the units are employed to assemble the whole picture display device, the display device becomes easy to handle and also easy to assemble. In this case, by way of example, each unit is formed to be of a square shape of 40cm in both height and width.

In the above picture display device, when the display signal for each display cell is transmitted, it is possible to perform the signal transmission in parallel for about 450,000 picture segments or elements. Thus, the signal transmission is carried out by a scanning method. In this case, however, since the structure of the display device is of a unit utilisation type, then if the known line-sequence scanning method is employed a large number of the connections between the respective units in the lateral direction is required, and, therefore, the work involved in the installation thereof becomes complicated.

Further, since the display device is a jumbo-size one, as explained above, if the signal transmission is carried out in an analog fashion it is easy for errors such as crosstalk, time-base errors and so on to be caused. Thus, consideration may be given to transmitting the signal in the form of a digital signal. However, if a flat cable is used as the transmission line, the transmission speed is generally suppressed to about 300kHz. On the other hand, the time to send the signal to the whole picture screen is limited to 1/30 second.

Further, in the above display device, the design of the display cell is such as to make it of poor linearity as regards the luminance variation, so as to make the device inexpensive, so that consideration may be given to performing the luminance-modulation for the device by pulse width modulation (PWM). However, a proposed circuit which carries out PWM is complicated and, by PWM at every 1/30 second, when the display time period becomes short, flicker becomes conspicuous at low luminance or the like.

According to a first aspect of the invention there is provided a video display system comprising: a video display system comprising: a video signal source for supplying a video signal of odd fields and even fields interlaced with each other; a first set of display cells for the odd fields; a second set of display cells for the even fields, arranged alternately with the first set of display cells in an interlaced fashion; first driving means coupled to the video signal source and the first set of display cells for receiving the video signal from the video signal source and for supplying the video signal for the odd fields to the first set of display cells during odd fields; and second driving means coupled to the video signal source and the second set of display cells for receiving the video signal from the video signal source and for supplying the video signal for the even fields to the second set of display cells during even fields; characterised in that the first driving means includes latching means for receiving and storing the video signal supplied by the first driving means to the first set of display cells during the odd fields and supplying the stored signal to the first set of display cells during even fields, and the second driving means includes latching means for receiving and storing the video signal supplied by the second driving means to the second set of display cells during the even fields and supplying the stored signal to the second set of display cells during odd fields.

A preferred form of video display system embodying the present invention and described hereinbelow possesses the advantages that: a signal can be transmitted easily; luminance modulation can be carried out effectively by a simple circuit construction; and it can be easily assembled and repaired.

The invention will now be further described, by way of illustrative and non-limiting example, with reference to the accompanying drawings, in which like references designate like elements and parts throughout, and in which:

Figure 1 is a front view of a luminescent display cell used in a video display system embodying the present invention;

Figure 2 is a sectional view taken on a line A-A in Figure 1;

Figure 3 is a sectional view taken on a line B-B in Figure 1;

Figure 4 is a partially cut-away perspective view of the luminescent display cell of Figure 1;

Figure 5 is an enlarged sectional view of a display segment of the display cell;

Figure 6 is a sectional view illustrative of the operation of a separator of the display cell;

Figure 7 is a perspective view of the separator;

Figure 8 is a plan view showing the separator disposed within an envelope;

Figure 9 is a sectional view of display segments and a portion of the separator;

Figure 10 is a sectional view showing an example of an alternative wire cathode that can be used in the display cell;

Figure 11 is a perspective view showing a mounted state of the wire cathode of Figure 10;

Figure 12 is a front view of a single unit incorporating a plurality of the display cells;

Figures 13A and 13B are perspective views showing other examples of display cells;

Figure 14 is a sectional view taken on a line C-C in Figure 12;

Figure 15 is a sectional view showing another method of mounting a display cell;

Figure 16 is a rear view of the structure shown in Figure 15;

Figures 17A and 17B are a front view and a cross-sectional view, respectively, of a built-up jumbo-size display device or system;

Figure 18 is a block diagram showing a video display system embodying the present invention;

Figures 19 and 21 are schematic diagrams showing a signal supplying arrangement of the system embodying the present invention;

Figures 20A to 20G are waveform diagrams used for explaining the operation of the video display system embodying the present invention; and

Figure 22 is a schematic diagram showing a PWM driving circuit used in the system embodying the present invention.

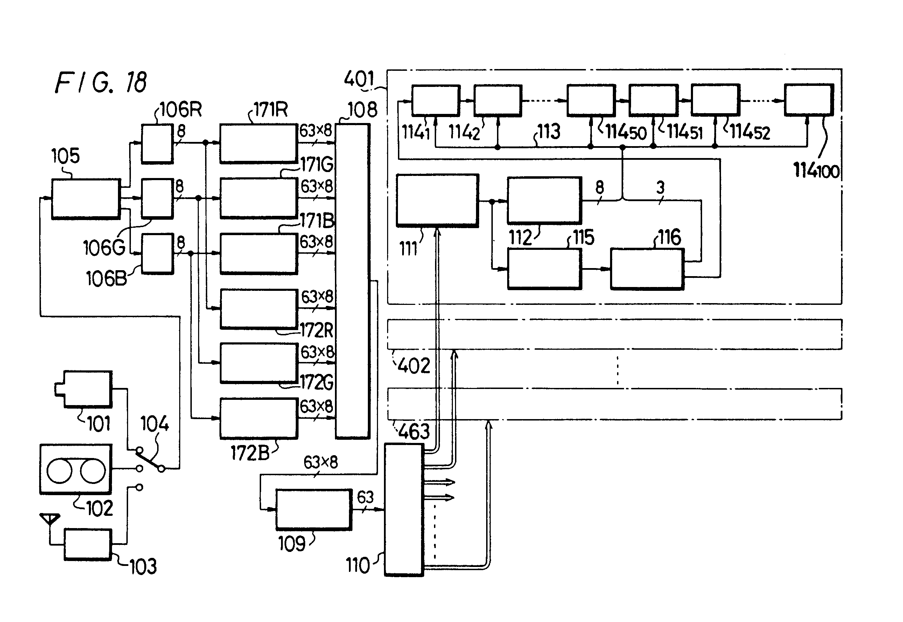

A video display system embodying the present invention will now be described with reference to Figures 18 to 22 of the accompanying drawings.

Figure 18 is a block diagram of an example of a video display system embodying the present invention. In this example, video signals from a television camera 101, a video tape recorder (VTR) 102, a tuner 103 and so on are selected by an input change-over switch 104. Each of these video signals is a composite video signal of, for example, the NTSC system. The video signal selected by the switch 104 is supplied to a decoder 105 in which it is decoded to three colour component signals of red, green and blue. These three colour component signals are supplied to respective analog to digital (A/D) converters 106R, 106G and 106B and then converted to respective 8 bit parallel digital signals.

These digital signals are supplied alternately to memories 171 (171R, 171G, 171B) and memories 172 (172R, 172G, 172B), each of which has a memory capacity of one field. The memories 171 and 172 each form a scanning converter which provides 4 horizontal lines from 5 horizontal lines. Further, for 189 horizontal lines, for example, selected from each field of the scanning converted signal, one output is derived at every 3 horizontal lines, totalling 63 (x 8 bit parallel) outputs.

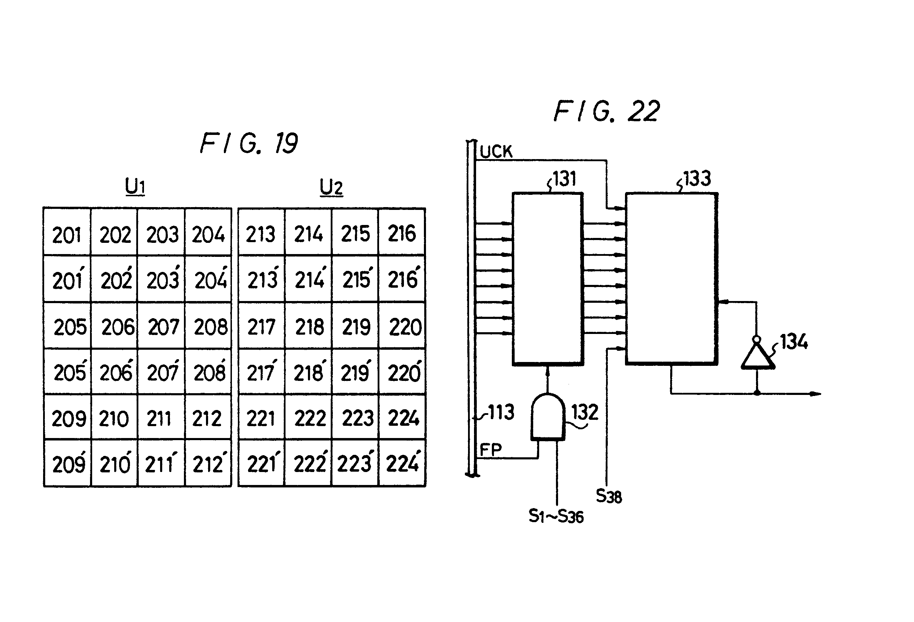

In this case, the order to derive the signal from the scanning converter is a specific one such that, after the supply of the signal to one of the units described previously is completed, the supply of the signal to the next neighbouring or adjacent unit will be carried out. That is, as shown in Figure 19, when there are two adjacent units $U_1$ and $U_2$, in one field the digital data for a segment corresponding to each cell is sequentially derived from one memory in the numbered order and, after the segment data corresponding to three horizontal lines 201 to 204, 205 to 208 and 209 to 212 in the left-hand unit $U_1$ is completely derived, the segment data corresponding to three horizontal lines 213 to 216, 217 to 220 and 221 to 224 in the right-hand unit $U_2$ is derived. Then, the segment data derivation is shifted to the right-hand side unit successively. The segment data corresponding to the horizontal lines marked by the corresponding numbers with prime superscripts (') in Figure 19 is derived from the other memory in the next field by interlace scanning.

This segment data is derived at the same time from the respective memories 171 or 172, respectively. This data derivation is carried out such that 63 items or pieces of data at every 3 lines are simultaneously derived. The data thus derived is supplied to a data selector 108 in which, at every field, the red, green and blue data is dot-sequentially selected from the memory in which no writing is carried out thereby to form the data signal of 63 (x 8 bit parallel). The so-formed data signal is fed to a multiplexer 109 in which 8 bit parallel signals are respectively converted to serial data signals. The signals thus converted are supplied to an optical converter 110 and then converted thereby to corresponding optical signals.

The optical signals of 63 items of data at every 3 horizontal lines are transmitted through optical-fibre cables 301, 302,...363 to centre portions of lateral groups 401, 402,...463 respectively where each group represents the total units of the display device laterally arranged.

Then, for example in the uppermost group 401 of the units, the optical signal from the optical-fibre cable 301 is fed to a photo-electric converter 111 and converted thereby to the corresponding electrical signal. This converted data signal is supplied to a demultiplexer 112 in which the serial data signal is converted to the 8 bit parallel signal. This parallel data signal is supplied through a bus line 113 to, for example, 100 units $114_1$, $114_2$,...$114_{100}$, which are laterally arranged, in parallel at the same time.

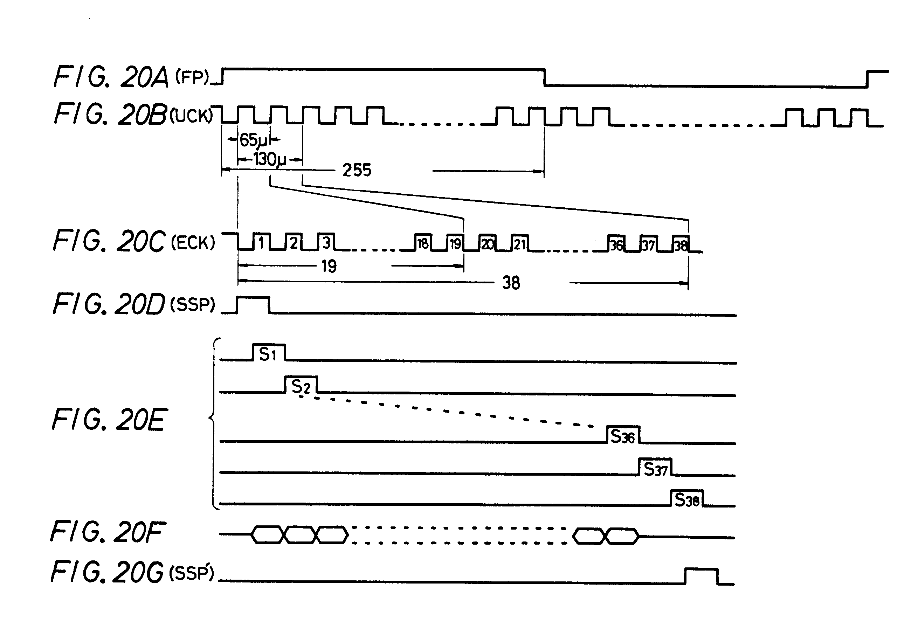

The signal from the photo-electric converter 111 is further supplied to a sync separator 115 in which synchronising signals are formed by a predetermined pattern generator and so on. The synchronising signals are fed to a timing generator circuit 116 which generates a frame pulse signal FP (Figure 20A) which is inverted at every field, a unit clock signal UCK (Figure 20B) which has 255 cycles during a half period (1 field) of the frame pulse signal, an element clock signal ECK (Figure 20C) which contains 38 cycles during two cycles of the unit clock signal UCK, and a start pulse SSP (Figure 20D) which is formed by one element clock signal amount at every inversion of the frame pulse signal. The frame pulse signal FP, unit clock signal UCK and element clock signal ECK are supplied, together with the above-mentioned data signal, through the bus line 113 to the respective units $114_1$, $114_2$,...$114_{100}$ in parallel while the start pulse SSP is supplied to the first unit $114_1$.

An operation similar to the above is carried out in each of the 63 groups 401,402,...463.

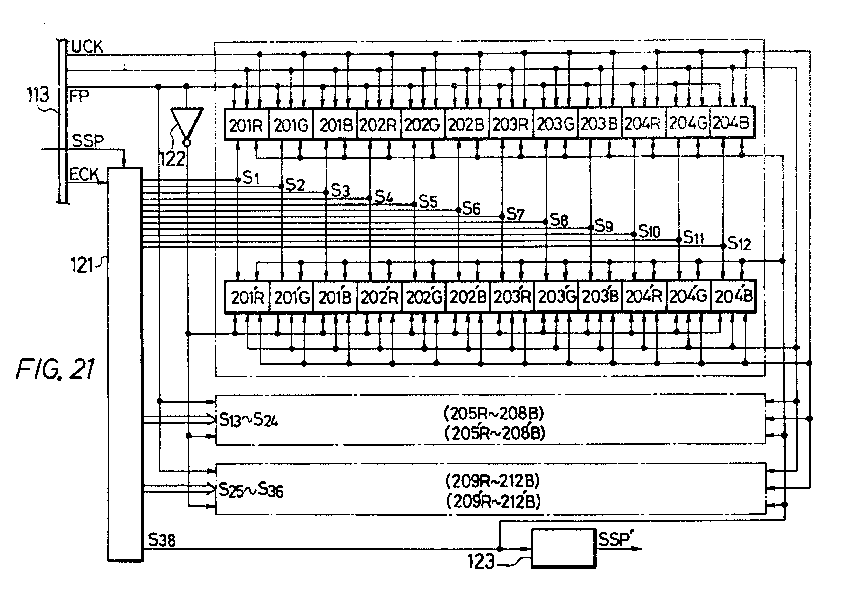

Each of the above units includes a signal translating circuit formed as shown in Figure 21. The circuit shown in Figure 21 includes a shift register 121 having 38 stages. The element clock signal ECK supplied from the timing generator circuit 116 through the bus line 113 is supplied to a clock input terminal of the shift register 121 and the start pulse SSP is supplied to a data input terminal of the shift register 121. Then, from the respective stages of the shift register 121, there are delivered sequentially shifted signals $S_1$, $S_2$,...$S_{38}$ as shown in Figures 20E. The signals $S_1$ to $S_{36}$ of the signals $S_1$ to $S_{38}$ are respectively supplied to display elements 201R, 201G, 201B, 202R, 202G, 202B,...212R, 212G, 212B of each of display cells 201 to 212 and to display elements 201'R, 201'G, 201'B, 202'R, 202'G, 202'B,...212'R, 212'G, 212'B of each of display cells 201' to 212'. In Figure 21, the circuits enclosed in chain-dotted line blocks are equivalent to one another.

The data signal, as shown in Figure 20F, from the bus line 113 is supplied to all of the elements 201R to 212'B in parallel. The frame pulse signal FP is supplied to the elements 201R to 212B and also is supplied to the elements 201'R to 212'B after being reversed in phase by an inverter 122.

The signal $S_{38}$ from the shift register 121 is supplied to a D-type flip-flop 123 which then produces a start pulse signal SSP' (Figure 20G) to be supplied to the next neighbouring unit.

A signal circuit used to drive each element is constructed as shown in Figure 22. In the circuit of Figure 22, an 8-bit latching circuit 131 is supplied at data input terminals thereof with the data signal from the bus line 113. An AND circuit 132 is supplied with the frame pulse signal FP, or its inverted signal, and one of the signals $S_1$ to $S_{36}$. The output from the AND circuit 132 is supplied to a control terminal of the latching circuit 131. An 8-bit down counter 133 is supplied at preset terminals thereof with the output from the latching circuit 131, at a load terminal thereof with the load pulse

(signal $S_{38}$) from the shift register 121, and at a clock input terminal thereof with the unit clock signal UCK from the bus line 113. When the counter 133 is in a condition other than an all-zero condition, it produces an output signal which is supplied to the first grid $G_1$ of each display element mentioned above. The output signal of the counter 133 is phase-inverted by an inverter 134 and then supplied to a count-stop terminal of the counter 133.

Accordingly, in each display element of each unit, at the timings of the signals $S_1$ to $S_{36}$, the data from the bus line 113 is latched into the latching circuit 131 of the corresponding element and then held therein. The data held therein is preset to the counter 133 at the timing of the signal $S_{38}$. The preset data is then counted down until the counter 133 becomes in an all-zero condition so that, at the output terminal of the counter 133, there is developed a PWM signal in accordance with each data signal. In this case, the counter 133 counts down the preset data in response to the unit clock signal UCK. Since this unit clock signal has 255 cycles during 1 field period, if the data is of largest value a display element is displayed during one field period continuously, while if the data is of smallest value the display element is not displayed, so that the display therebetween can be divided into 256 brightness steps. The first grid of each element can be driven by the PWM signal.

Further, at the timing of the signal $S_{38}$, the start pulse signal for the next neighbouring unit is produced. Thereafter, an operation similar to the above-described operation is sequentially carried out for 100 laterally arranged units. Moreover, the data latching operation of each unit is performed during the 2-cycle period of the unit clock signal UCK so that such operation for 100 laterally arranged units is completed in 200 cycles. Therefore, by utilising the remaining 55 cycles, special control signals such as the synchronising signal and so on can be transmitted.

Since in the next field the frame pulse signal FP is inverted in phase, a similar operation is carried out for the other picture elements of the interlace scanning. At this time, the preset pulse is supplied to the picture or display elements which were driven in the previous field, so that the same display is performed twice on each picture element during the successive 2 field intervals.

Thus, display operations are performed on 100 units which are laterally arranged. Further, such display is performed for the 63 vertical direction groups of units in parallel at the same time, whereby a whole picture is displayed.

Thus, a jumbo-size picture of 25 m (column) x 40 m (row) is displayed. According to the above picture display system, since the data is sequentially transmitted at every unit and, after the data transmission of one display unit is completed, the data of the next neighbouring display unit is transmitted, the display operation is completed at each unit. As a result, the wiring between the respective units need comprise only one line to transmit the start pulse SSP' from one unit to the next unit, so that the connections between the units become quite simple. The supply of the data signal and so on from the bus line to each unit can be performed by using a multi-contact connector.

Therefore, when the units are attached, exchanged or the like, the work involved is simple and the assembly and repair thereof become quite easy. For example, when one unit becomes out of order, it is sufficient for the defective unit to be replaced by a new good unit. Since the number of the lines for electrical connection is small, the replacement can be done rapidly and easily. Further, a risk that trouble may be caused by contact miss and so on can be reduced.

Further, as an emergency measure, it is sufficient for a counter which can count up to 38 to be connected between the input and output terminals for the start pulse of a defective unit and then for this defective unit to be removed. In this case, no adverse effect is exerted on the other units. Furthermore, when the operation of a certain unit itself is checked, since the signal is completed within the unit the check is very easy.

Also, since the data is transmitted in parallel to every laterally arranged unit, the transmission speed is made low. That is, the data transmission speed in the above embodiment becomes as follows.

$$60 \times 255 \times \frac{38}{2} = 290.7 \text{ (kHz)}$$

This speed is lower than the tolerable range (300 kHz) of a flat cable (bus line), so that it becomes possible for a conventional flat cable to be employed.

Furthermore, in the above example, since the PWM circuit is formed by using a down counter, it can be constructed very simply.

Further, the data transmission is such that the data of 2-field amounts of the interlace scanning is transmitted in one frame interval and the data is rewritten only once in each picture element at one frame interval. However, the display is repeated in sequential 2 fields and the display frequency is 60 Hz so that the generation of flicker can be suppressed.

According to the video display system set forth above, the signal transmission becomes simple and luminance modulation can be carried out effectively by a simple circuit construction.

Further, assembly and repair of the parts become easy.

## Claims

1. A video display system comprising:
   a video signal source (101, 102, 103) for supplying a video signal of odd fields and even fields interlaced with each other;
   a first set of display cells (201, 202, 203, ...) for the odd fields;
   a second set of display cells (201, 202, 203, ...) for the even fields, arranged alternately with the first set of display cells in an interlaced fashion;
   first driving means (121, 122, 123) coupled to the video signal source and the first set of display cells for receiving the video signal from the video signal source and for supplying the video signal for the odd fields to the first set of display cells during odd fields; and
   second driving means (121, 122, 123) coupled to the video signal source and the second set of display cells for receiving the video signal from the video signal source and for supplying the video signal for the even fields to the second set of display cells during even fields; characterised in that
   the first driving means includes latching means (131) for receiving and storing the video signal supplied by the first driving means to the first set of display cells during the odd fields and supplying the stored signal to the first set of display cells during even fields, and
   the second driving means includes latching means (131) for receiving and storing the video signal supplied by the second driving means to the second set of display cells during the even fields and supplying the stored signal to the second set of display cells during odd fields.

2. A video display system according to claim 1, wherein the latching means (131) of the first and second means includes a pulse width modulation circuit for controlling the brightness of the display cells in accordance with the video signal.

3. A video display system according to claim 2, wherein the pulse width modulation circuit includes a counter (133) which is arranged to be supplied with the stored signal as preset data and is operative to count down the preset data with clock signals applied thereto.

4. A video display system as claimed in any one of the preceding claims, wherein the first and second sets of display cells are separated into a plurality of units, each unit including display cells arranged in an X-Y matrix form and being coupled to a respective one of the first driving means and the second driving means, the first driving means and the second driving means supplying the video signal to the units in an order in which the display cells included in one unit are supplied with the video signal to complete the whole display of the one unit before the display cells included in a succeeding unit are supplied with the video signal to complete the whole display of the succeeding unit.

## Patentansprüche

1. Videoanzeigesystem mit
   einer Videosignalquelle (101, 102, 103) zum Zuführen eines Videosignals aus miteinander verschachtelten ungeradzahligen Feldern (Teilbildern) und geradzahligen Feldern (Teilbildern),
   einem ersten Satz Anzeigezellen (201, 202, 203, ...) für die ungeradzahligen Felder, einem zweiten Satz Anzeigezellen (201, 202, 203, ...) für die geradzahligen Felder, der in verschachtelter Weise abwechselnd zum ersten Satz Anzeigezellen angeordnet ist,
   einer an die Videosignalquelle und den ersten Satz Anzeigezellen gekoppelten ersten Ansteuereinrichtung (121, 122, 123) zum Empfang des Videosignals aus der Videosignalquelle und zum Zuführen des Videosignals für die ungeradzahligen Felder zum ersten Satz Anzeigezellen während ungeradzahliger Felder, und
   einer an die Videosignalquelle und den zweiten Satz Anzeigezellen gekoppelten zweiten Ansteuereinrichtung (121, 122, 123) zum Empfang des Videosignals aus der Videosignalquelle und zum Zuführen des Videosignals für die geradzahligen Felder zum zweiten Satz Anzeigezellen während geradzahliger Felder, dadurch **gekennzeichnet,**
   daß die erste Ansteuereinrichtung eine Verriegelungseinrichtung (131) zum Empfang und Speichern des während ungeradzahliger Felder durch die erste Ansteuereinrichtung zum ersten Satz Videosignalzellen zugeführten Videosignals und Zuführen des gespeicherten Signals zum ersten Satz Videozellen während geradzahliger Felder aufweist, und
   die zweite Ansteuereinrichtung eine Verriegelungseinrichtung (131) zum Empfang und Speichern des während der geradzahligen Felder durch die zweite Ansteuereinrichtung zum zweiten Satz Anzeigezellen zugeführten Videosignals und Zuführen des gespeicherten Signals zum zweiten Satz Anzeigezellen während ungeradzahliger Felder aufweist.

2.  Videoanzeigesystem nach Anspruch 1, wobei die Verriegelungseinrichtung (131) der ersten und zweiten Einrichtung eine Impulsbreitenmodulationsschaltung zum Steuern der Helligkeit der Anzeigezellen in Übereinstimmung mit dem Videosignal aufweist.

3.  Videoanzeigesystem nach Anspruch 2, wobei die Impulsbreitenmodulationsschaltung einen Zähler (133) aufweist, der so angeordnet oder ausgebildet ist, daß ihm das gespeicherte Signal als voreingestellte Daten zuführbar ist, und der so betreibbar ist, daß er die voreingestellten Daten mit an ihn angelegten Taktsignalen herabzählt.

4.  Videoanzeigesystem nach einem der vorhergehenden Ansprüche, wobei der erste und zweite Satz Anzeigezellen in mehrere Einheiten unterteilt ist, wobei jede Einheit Anzeigezellen enthält, die in einer X-Y-Matrixform angeordnet und an die erste oder zweite Ansteuereinrichtung gekoppelt sind, wobei die erste Ansteuereinrichtung und die zweite Ansteuereinrichtung das Videosignal den Einheiten in einer Reihenfolge zuführen, bei welcher die in einer Einheit enthaltenen Anzeigezellen mit dem Videosignal versorgt sind, um die ganze Anzeige der einen Einheit zu vervollständigen, bevor die in einer folgenden Einheit enthaltenen Anzeigezellen mit dem Videosignal versorgt werden, um die ganze Anzeige der folgenden Einheit zu vervollständigen.

**Revendications**

1.  Un système de visualisation vidéo comprenant :
    une source de signal vidéo (101, 102, 103) qui est destinée à fournir un signal vidéo de trames impaires et de trames paires mutuellement entrelacées ;
    un premier ensemble de cellules de visualisation (201, 202, 203, ...) pour les trames impaires ;
    un second ensemble de cellules de visualisation (201, 202, 203, ...) pour les trames paires, disposé en alternance avec le premier ensemble de cellules de visualisation, d'une manière entrelacée ;
    des premiers moyens d'attaque (121, 122, 123) connectés à la source de signal vidéo et au premier ensemble de cellules de visualisation, pour recevoir le signal vidéo provenant de la source de signal vidéo et pour appliquer le signal vidéo pour les trames impaires au premier ensemble de cellules de visualisation pendant des trames impaires ; et
    des seconds moyens d'attaque (121, 122, 123) connectés à la source de signal vidéo et au second ensemble de cellules de visualisation, pour recevoir le signal vidéo provenant de la source de signal vidéo et pour appliquer le signal vidéo pour les trames paires au second ensemble de cellules de visualisation, pendant des trames paires ; caractérisé en ce que
    les premiers moyens d'attaque comprennent des moyens de mémorisation (131) qui sont destinés à recevoir et à enregistrer le signal vidéo qui est appliqué par les premiers moyens d'attaque au premier ensemble de cellules de visualisation pendant les trames impaires, et à appliquer le signal enregistré au premier ensemble de cellules de visualisation pendant les trames paires, et
    les seconds moyens d'attaque comprennent des moyens de mémorisation (131) qui sont destinés à recevoir et à enregistrer le signal vidéo qui est appliqué par les seconds moyens d'attaque au second ensemble de cellules de visualisation pendant les trames paires, et à appliquer le signal enregistré au second ensemble de cellules de visualisation pendant les trames impaires.

2.  Un système de visualisation vidéo selon la revendication 1, dans lequel les moyens de mémorisation (131) des premiers et seconds moyens comprennent un circuit de modulation d'impulsions en largeur qui est destiné à commander la luminance des cellules de visualisation conformément au signal vidéo.

3.  Un système de visualisation vidéo selon la revendication 2, dans lequel le circuit de modulation d'impulsions en largeur comprend un compteur (133) qui est conçu de façon à recevoir le signal enregistré, à titre de données de prépositionnement, et qui réagit à des signaux d'horloge qui lui sont appliqués, en comptant en sens décroissant les données de prépositionnement.

4.  Un système de visualisation vidéo selon l'une quelconque des revendications précédentes, dans lequel les premier et second ensembles de cellules de visualisation sont séparés en un ensemble d'unités, chaque unité comprenant des cellules de visualisation disposées sous la forme d'une matrice X-Y et étant connectée respectivement aux premiers moyens d'attaque ou aux seconds moyens d'attaque, les premiers moyens d'attaque et les seconds moyens d'attaque appliquant le signal vidéo aux unités dans l'ordre dans lequel les cellules de visualisation qui sont incluses dans une unité reçoivent le signal vidéo, pour effectuer entièrement la visualisation pour une unité avant que les cellules de visualisation qui sont incluses dans une unité suivante ne reçoivent le signal vidéo, pour effectuer entièrement la visualisation pour l'unité suivante.

FIG. 1

FIG. 2

*F I G. 3*

*F I G. 5*

FIG. 4

## FIG. 6

## FIG. 9

FIG. 7

FIG. 8

## FIG. 10

## FIG. 11

FIG. 12

40    40    41

C    C

FIG. 13A

40    1B
1C
1A
50

FIG. 13B

40    1B
1C
1A
50

## F I G. 14

## F I G. 15

## F I G. 16

FIG. 17A

FIG. 17B

EP 0 149 550 B1

FIG. 18

EP 0 149 550 B1

## F I G. 19

| U1 | | | | U2 | | | |
|---|---|---|---|---|---|---|---|
| 201 | 202 | 203 | 204 | 213 | 214 | 215 | 216 |
| 201′ | 202′ | 203′ | 204′ | 213′ | 214′ | 215′ | 216′ |
| 205 | 206 | 207 | 208 | 217 | 218 | 219 | 220 |
| 205′ | 206′ | 207′ | 208′ | 217′ | 218′ | 219′ | 220′ |
| 209 | 210 | 211 | 212 | 221 | 222 | 223 | 224 |
| 209′ | 210′ | 211′ | 212′ | 221′ | 222′ | 223′ | 224′ |

## F I G. 22

FIG. 20A (FP)

FIG. 20B (UCK)

65μ
130μ
255

FIG. 20C (ECK)

1 2 3 ... 18 19 20 21 ... 36 37 38

19
38

FIG. 20D (SSP)

FIG. 20E

S1
S2
S36
S37
S38

FIG. 20F

FIG. 20G (SSP')

EP 0 149 550 B1

FIG. 21